# DEMANDE DE BREVET EUROPEEN

(11) **EP 4 141 915 A1**
(43) Date de publication de la demande: **01.03.2023**
(21) Numéro de dépôt: 22191305.6
(22) Date de dépôt: 19.08.2022
(51) Int. Cl.: H01L 21/56, H01L 21/78, H01L 23/48, H01L 23/31

(54) **PROCÉDÉ DE FABRICATION D'UNE PUCE ÉLECTRONIQUE ENCAPSULÉE À L'ÉCHELLE DE LA PUCE AINSI QUE LE DISPOSITIF CORRESPONDANT**

(30) Priorité: 31.08.2021 FR 2109092
(71) Demandeur: STMicroelectronics (Tours) SAS, 37100 Tours (FR)
(72) Inventeur: ORY, Olivier, 37100 TOURS (FR); DE CRUZ, Michael, 37380 MONNAIE (FR)
(74) Mandataire: Cabinet Beaumont

(57) **Abrégé**

La présente description concerne un procédé de fabrication de puces électroniques (1) comprenant, dans l'ordre :
a. la formation de contacts métalliques (19) du côté d'une première face d'un substrat semiconducteur (11), dans et sur lequel ont été préalablement formés une pluralité de circuits intégrés (13) ;
b. le dépôt d'une première résine de protection (21) sur les contacts métalliques et la première face du substrat semiconducteur ;
c. la formation de premières tranchées (23) d'une première largeur, du côté d'une deuxième face du substrat semiconducteur (11) ;
d. le dépôt d'une deuxième résine de protection (25) dans les premières tranchées et sur la deuxième face du substrat semiconducteur (11) ;
e. la formation de deuxièmes tranchées (27), d'une deuxième largeur (L4) inférieure à la première largeur , en vis-à-vis des premières tranchées (23) jusqu'aux contacts métalliques ; et
f. la formation de troisièmes tranchées (29), en vis-à-vis des deuxièmes tranchées (27), les troisièmes tranchées (29) traversant les contacts métalliques (19). La description divulgue également le dispositif obtenu par ledit procédé.

## Description

### Domaine technique

La présente description concerne la fabrication de puces électroniques. Elle vise plus particulièrement la fabrication de puces dites à montage en surface, c'est-à-dire comportant, du côté d'au moins une face, une ou plusieurs métallisations de connexion destinées à être brasées à des plages de connexion correspondantes situées sur une face de connexion d'un dispositif externe, par exemple une carte de circuit imprimé ou une autre puce.

### Technique antérieure

De façon classique, les métallisations de connexion d'une puce à montage en surface sont disposées du côté de la face inférieure de la puce, c'est-à-dire du côté de la face de la puce tournée vers la face de connexion du dispositif externe. Une fois l'assemblage réalisé, les métallisations de connexion de la puce sont donc masquées par la puce. Toutefois, pour certaines applications, il existe un besoin pour des puces à montage en surface permettant une inspection visuelle de la qualité des brasures des puces et plus particulièrement de leurs métallisations sur un dispositif externe. Ce besoin existe par exemple dans le domaine automobile ou le domaine médical et, plus généralement, dans les domaines où l'on souhaite garantir la fiabilité des connexions électriques, une fois les circuits montés dans leur environnement.

Il serait souhaitable d'améliorer au moins en partie certains aspects des procédés connus de fabrication de puces électroniques.

On s'intéresse ici notamment à la réalisation de puces encapsulées dans des boitiers de type CSP (de l'anglais "Chip-Scale Package", boitier à l'échelle de la puce). Plus particulièrement, on cherche à réaliser des puces de type CSP permettant une inspection visuelle de la qualité des brasures par observation au moyen d'une caméra placée au dessus des puces.

### Résumé de l'invention

Un mode de réalisation prévoit un procédé de fabrication de puces électroniques comprenant, dans l'ordre :
a. la formation de contacts métalliques du côté d'une première face d'un substrat semiconducteur, dans et sur lequel ont été préalablement formés une pluralité de circuits intégrés, chaque contact métallique s'étendant à l'aplomb d'au moins deux circuits intégrés voisins ;
b. le dépôt d'une première résine de protection sur les contacts métalliques et la première face du substrat semiconducteur ;
c. la formation de premières tranchées d'une première largeur, du côté d'une deuxième face du substrat semiconducteur opposée à la première face, les premières tranchées s'étendant entre les circuits intégrés sur toute la hauteur du substrat semiconducteur ;
d. le dépôt d'une deuxième résine de protection dans les premières tranchées et sur la deuxième face du substrat semiconducteur ;
e. la formation de deuxièmes tranchées, d'une deuxième largeur inférieure à la première largeur, dans la deuxième résine de protection, en vis-à-vis des premières tranchées, les deuxièmes tranchées s'étendant jusqu'aux contacts métalliques ; et
f. la formation de troisièmes tranchées, d'une troisième largeur inférieure à la deuxième largeur, en vis-à-vis des deuxièmes tranchées, les troisièmes tranchées traversant les contacts métalliques de façon à individualiser les puces électroniques.

Selon un mode de réalisation, le procédé comprend, après l'étape b., une étape d'amincissement de la première résine de protection de façon à découvrir les contacts métalliques.

Selon un mode de réalisation, le procédé comprend, avant l'étape a., une étape de formation de plots de reprise de contact du côté de la première face du substrat semiconducteur, les contacts métalliques étant formés, lors de l'étape a., sur et en contact avec les plots de reprise de contact.

Selon un mode de réalisation, les contacts métalliques ont une hauteur comprise entre 20 µm et 150 µm.

Selon un mode de réalisation, la troisième largeur est inférieure à 20 µm.

Selon un mode de réalisation, la deuxième largeur est comprise entre 30 µm et 310 µm.

Selon un mode de réalisation, le procédé comprend, après l'étape a., une étape d'amincissement du substrat semiconducteur par sa deuxième face.

Selon un mode de réalisation, ladite étape d'amincissement du substrat semiconducteur est mise en oeuvre avant l'étape c..

Selon un mode de réalisation, ladite étape d'amincissement du substrat semiconducteur est mise en oeuvre après l'étape d..

Un mode de réalisation prévoit une puce électronique comportant un circuit intégré formé dans et sur un substrat semiconducteur, les flancs du substrat étant revêtus par une deuxième résine de protection, la puce comportant au moins un contact métallique disposé sur une première face du substrat semiconducteur et s'étendant latéralement au-delà des flancs de la deuxième résine de protection.

Selon un mode de réalisation, ledit au moins un contact métallique présente une face de connexion plane s'étendant de façon continue en partie sous le substrat semiconducteur et se prolongeant latéralement au-delà des flancs de la deuxième résine de protection.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, par une vue en coupe et une vue de dessous, un exemple d'un mode de réalisation d'une puce électronique à montage en surface ;
la figure 2 illustre, par une vue en coupe, une étape d'un exemple de procédé de fabrication de la puce électronique illustrée en figure 1 ;
la figure 3 illustre, par une vue en coupe, une autre étape d'un exemple de procédé de fabrication de la puce électronique illustrée en figure 1 ;
la figure 4 illustre, par une vue en coupe, encore une autre étape d'un exemple de procédé de fabrication de la puce électronique illustrée en figure 1 ;
la figure 5 illustre, par une vue en coupe, encore une autre étape d'un exemple de procédé de fabrication de la puce électronique illustrée en figure 1 ;
la figure 6 illustre, par une vue en coupe, encore une autre étape d'un exemple de procédé de fabrication de la puce électronique illustrée en figure 1 ;
la figure 7 illustre, par une vue en coupe, encore une autre étape d'un exemple de procédé de fabrication de la puce électronique illustrée en figure 1 ;
la figure 8 illustre, par une vue en coupe, encore une autre étape d'un exemple de procédé de fabrication de la puce électronique illustrée en figure 1 ; et
la figure 9 illustre, par une vue en coupe, encore une autre étape d'un exemple de procédé de fabrication de la puce électronique illustrée en figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des circuits intégrés présents dans les puces électroniques décrites n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe des figures correspondantes.

Sauf précision contraire, les expressions "environ", "approximativement", "sensiblement", et "de l'ordre de" signifient à 10 % près, de préférence à 5 % près.

On a déjà proposé des puces à montage en surface comportant des métallisations de connexion qui s'étendent jusqu'aux flancs des puces. On parle de puces à flancs mouillables (en anglais "wettable flanck"). Lors du montage de la puce sur un dispositif externe, par exemple, sur une carte de circuit imprimé, les métallisations de connexion de la puce sont soudées ou brasées à des pistes ou éléments métalliques correspondants du dispositif externe. Une partie du matériau de brasage remonte alors sur les flancs des puces, ce qui permet de mettre en oeuvre une inspection visuelle de la qualité des brasures.

Une puce à flancs mouillables comporte classiquement des métallisations de connexion ayant une hauteur (épaisseur) relativement importante afin que le contrôle visuel du brasage de la puce puisse être facilement mis en oeuvre.

Cette hauteur peut restreindre les possibilités de miniaturisation des circuits électroniques basés sur de telles puces.

Selon un aspect des modes de réalisation décrits ci-après, on prévoit de prolonger horizontalement les métallisations de connexion en dehors du boitier de la puce. Ceci permet de mettre en oeuvre une inspection visuelle de la qualité des connexions, tout en limitant l'épaisseur des métallisations de connexion de la puce.

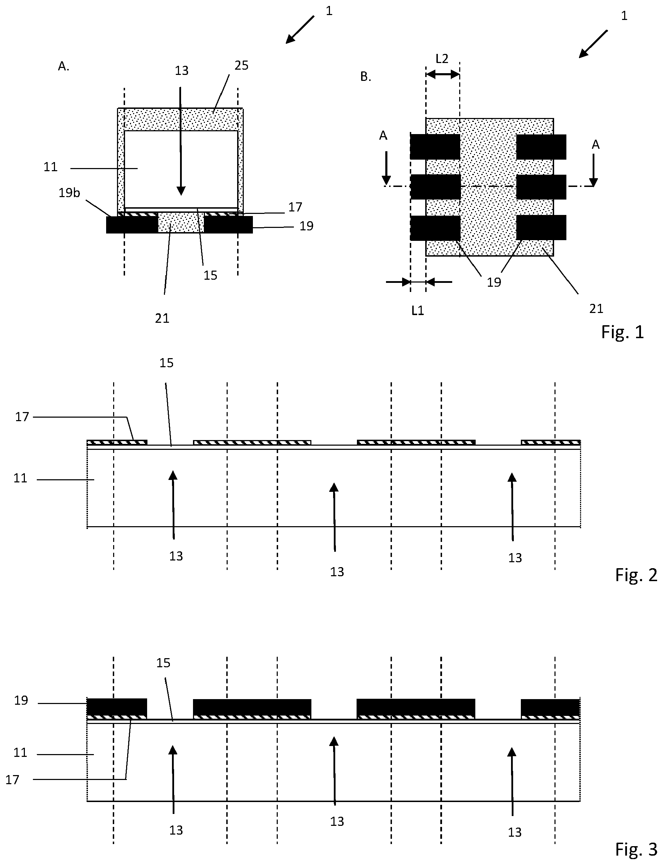

La figure 1 illustre, par une vue A en coupe et une vue B de dessous, un mode de réalisation d'une puce électronique, la vue A étant une vue en coupe selon le plan de coupe AA de la vue B.

La puce électronique 1 comprend un substrat semi-conducteur 11 dans et sur lequel est formé un circuit intégré 13. Le substrat 11 est en un matériau semi-conducteur, par exemple du silicium. Du côté de sa face inférieure (dans l'orientation de la vue A), le substrat 11 est revêtu par et en contact avec un empilement de couches isolantes et conductrices 15 appelé empilement d'interconnexion, dans lequel peuvent être formés des éléments d'interconnexion de composants du circuit 13. L'empilement d'interconnexion 15 comprend en outre, un ou plusieurs plots électriquement conducteurs de reprise de contact 17, par exemple métalliques, débouchant à la surface de l'empilement 15. Dans l'exemple représenté, la puce comprend six plots 17. Les modes de réalisation décrits ne se limitent toutefois pas à ce cas particulier. A titre de variante, la puce 1 peut comprendre un nombre de plots 17 différent de six, par exemple, cinq plots 17 ou huit plots 17. Les plots 17 sont situés en périphérie de l'empilement 15 comme cela a été représenté en figure 1. L'espacement entre deux plots 17 est, par exemple supérieur à 50 µm.

Les plots 17 s'étendent, latéralement, au-delà de la structure formée par le substrat 11 et l'empilement 15. En d'autres termes, les bords latéraux de la structure formée par le substrat 11 et l'empilement 15 ne sont pas alignés avec les bords latéraux des plots 17.

La structure formée par le substrat 11 et l'empilement 15 a par exemple une forme parallélépipédique.

La puce 1 illustrée en figure 1 comprend en outre des métallisations de connexion ou contacts métalliques 19. Chaque contact métallique 19 est formé sur et en contact avec un plot de reprise de contact 17. Les plots 17 sont, de préférence, tous recouverts par au moins une partie d'un contact métallique 19. Les contacts métalliques 19 s'étendent latéralement au-delà des flancs de la structure formée par le substrat 11 et l'empilement 15. Les parties de la structure, formée par le substrat 11, l'empilement 15 et les plots de reprise de contact 17, qui ne sont pas recouvertes par un contact métallique 19, sont recouvertes par une résine de protection électriquement isolante formant un boîtier de la puce. Par exemple, la face supérieure et une partie des bords latéraux de la structure sont recouvertes par une région de résine 25 et une partie de la face inférieure de la structure est recouverte par une région de résine 21. A titre d'exemple, la résine de protection laisse apparents uniquement les contacts métalliques 19 de la puce. Dans cet exemple, les contacts métalliques 19 affleurent du côté de la face inférieure de la résine 21 de protection.

Selon un aspect des modes de réalisation décrits, les contacts métalliques 19 s'étendent, latéralement, au-delà des flancs du boîtier formé par la résine de protection. A titre d'exemple, en vue de dessous, une portion 19b de chaque contact métallique 19 s'étend au-delà des flancs du boîtier sur une distance L1 comprise, par exemple, entre 10 µm et 150 µm (dans une direction orthogonale au flanc du boîtier de la puce). Autrement dit, chaque contact métallique 19 s'étend en partie sous le substrat 11 et se prolonge latéralement au-delà du boîtier de la puce. Ainsi, chaque contact métallique 19 présente une surface inférieure de connexion plane s'étendant de façon continue, en partie sous le substrat 11, et se prolongeant latéralement au-delà des flancs du boîtier de la puce.

Les portions 19b en saillie des flancs de la puce forment des pattes de connexion permettant une inspection visuelle de la qualité des connexions de la puce à un dispositif extérieur.

La longueur L2 des portions des contacts métalliques 19 situées sous le boitier de la puce est, par exemple, supérieure à 50 µm.

La brasure de la puce 1 sur un dispositif extérieur illustrée en figure 1 est par exemple effectuée par dépôt d'une pâte de brasage sur la face inférieure des contacts métalliques 19.

Un avantage résultant de la présence des pattes 19b des métallisations de connexion 19 en saillie des flancs du boîtier de la puce 1 est que, lors de la brasure de la puce 1 sur un dispositif extérieur, un contrôle visuel de la qualité de la brasure est possible. En particulier, lors de l'assemblage, une partie du matériau de brasure peut remonter sur les flancs et sur la face supérieure des pattes 19b, ce qui facilite le contrôle visuel de la connexion.

Les figures 2 à 9 sont des vues en coupe illustrant des étapes successives d'un exemple d'un procédé de fabrication de puces électroniques du type décrit en relation avec la figure 1.

La figure 2 est une vue en coupe d'une structure comprenant le substrat semi-conducteur 11 dans et sur lequel des circuits intégrés 13 ont été préalablement formés. Les circuits 13 sont par exemple tous identiques aux dispersions de fabrication près. Le substrat 11 peut correspondre à une plaquette d'un matériau semi-conducteur, par exemple du silicium. Le substrat 11 a, par exemple, une épaisseur comprise entre 50 µm et 900 µm, par exemple entre 50 µm et 500 µm, par exemple une épaisseur d'environ 500 µm.

La structure de la figure 2 comprend en outre l'empilement de couches isolantes et conductrices 15 revêtant la face supérieure du substrat 11. L'empilement d'interconnexion 15 comprend en outre, du côté de sa face supérieure, pour chaque circuit intégré 13, un ou plusieurs plots de reprise de contact 17. Les plots de reprise de contact 17 sont, par exemple, communs à plusieurs circuits intégrés 13. A titre d'exemple, un même plot de reprise de contact 17 s'étend sur au moins deux circuits intégrés 13 voisins, ainsi que sur une zone de découpe située entre les deux circuits intégrés. Les plots de reprise de contact 17 peuvent comprendre un empilement d'une ou plusieurs couches métalliques. Les plots de reprise de contact 17 sont par exemple des métallisations sous bossage (UBM, de l'anglais "Under Bump Metallization").

Chaque circuit intégré 13 comprend, par exemple, un ou plusieurs composants électroniques (transistors, diodes, thyristors, triacs, etc.).

En figure 2, trois circuits intégrés 13 ont été représentés, étant entendu que le nombre de circuits intégrés 13 formés dans et sur le substrat 11 peut être différent de trois. En pratique, le substrat 11 est une plaquette en un matériau semi-conducteur, par exemple, du silicium, et plusieurs dizaines voire plusieurs centaines ou milliers de circuits intégrés 13 sont formés dans et sur le substrat 11. Les circuits intégrés 13 sont alors, par exemple, organisés en réseau en lignes et en colonnes en suivant un quadrillage régulier.

Dans la suite de cette description, on considère, dans l'orientation de la figure 2, la face inférieure de la structure, comme étant la face arrière et la face supérieure de la structure, comme étant la face avant.

La figure 3 illustre, par une vue en coupe, une étape de formation de contacts métalliques 19 en face avant de la structure illustrée en figure 2.

Plus particulièrement, lors de l'étape illustrée en figure 3, on vient former, à l'aplomb de chaque plot de reprise de contact 17, sur et en contact avec le plot 17, un contact métallique 19. Les contacts métalliques 19 recouvrent par exemple toute la surface des plots de reprise de contact 17. A titre d'exemple, en vue de dessus, les contours des contacts métalliques 19 coïncident avec les contours des plots de reprise de contact 17.

Les contacts métalliques 19 sont par exemple fabriqués par croissance électrolytique à partir de la face supérieure des plots 17. La hauteur (épaisseur) des contacts métalliques 19 est, par exemple, supérieure ou égale à 20 µm, par exemple supérieure ou égale à 50 µm. A titre d'exemple, la hauteur des contacts métalliques 19 est comprise entre 20 µm et 150 µm.

Les contacts métalliques 19 peuvent être en un alliage à base d'étain, par exemple un alliage à base d'étain et d'argent (SnAg). En variante, les contacts métalliques 19 peuvent être en cuivre, en or, en argent, en un alliage à base de nickel, par exemple un alliage de nickel palladium et/ou de nickel or électrolytique, ou en un alliage à base d'un ou plusieurs de ces matériaux.

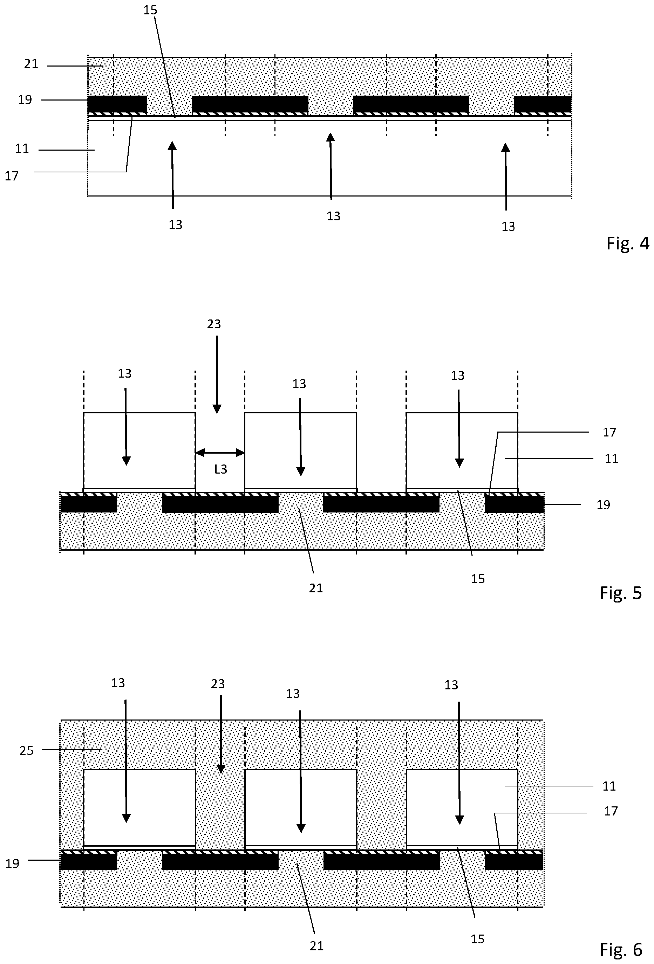

La figure 4 illustre, par une vue en coupe, une étape de dépôt d'une résine de protection 21 en face avant de la structure illustrée en figure 3.

Lors de cette étape, on vient recouvrir intégralement (pleine plaque) la face avant de la structure par la résine 21, et en particulier les contacts métalliques 19 et la face supérieure de l'empilement 15. La résine 21 est, par exemple, une résine époxy. La résine 21 permet d'isoler électriquement la face avant de la puce finale (c'est-à-dire la face inférieure dans l'orientation de la vue A de la figure 1).

La résine 21 présente de préférence une épaisseur relativement importante de façon à rigidifier la structure pour les étapes suivantes. La résine 21 sert alors de support mécanique pour les étapes suivantes et notamment les étapes de découpe. A titre d'exemple, la résine 21 est déposée avec une épaisseur, à partir de la face supérieure de l'empilement 15, comprise entre 100 µm et 500 µm.

La figure 5 illustre, par une vue en coupe, une étape de formation de premières tranchées de découpe 23 à partir de la face arrière de la structure illustrée en figure 4.

On notera que dans l'exemple de la figure 5, l'orientation de la structure est inversée par rapport aux vues en coupe des figures précédentes.

A titre d'exemple, lors de l'étape de formation des tranchées 23, la structure est supportée par un film support non représenté disposé du côté de la face inférieure de la couche de résine 21 dans l'orientation de la figure 5.

Les tranchées 23 s'étendent entre les circuits 13 de sorte que chaque circuit 13 soit séparé latéralement de son voisin par une tranchée 23. A titre d'exemple, chaque circuit 13 est entièrement délimité, latéralement, par des tranchées 23. Les tranchées 23 peuvent, par exemple, en vue de dessus, former une grille continue s'étendant entre les circuits intégrés 13.

Dans l'exemple représenté, les tranchées 23 s'étendent verticalement, depuis la face arrière du substrat 11 (c'est-à-dire la face supérieure dans l'orientation de la figure 5), et se prolongent dans le substrat 11, sur au moins toute l'épaisseur du substrat 11. Les tranchées 23 se prolongent, par exemple dans tout ou partie de l'épaisseur de l'empilement 15 et, par exemple dans tout ou partie de l'épaisseur des plots 17. Les tranchées 23 débouchent, par exemple, sur ou dans les plots 17. En variante, les tranchées 23 débouchent sur ou dans les contacts métalliques 19. Dans l'exemple représenté, les tranchées 23 débouchent sur la face supérieure des plots 17, c'est-à-dire sur la face des plots 17 opposée aux contacts métalliques 19.

Les tranchées 23 sont, par exemple, réalisées par découpe plasma. A titre de variante, les tranchées 23 sont réalisées par sciage à l'aide d'une lame.

Les tranchées 23 ont une largeur L3, par exemple comprise entre 100 µm et 200 µm.

La figure 6 illustre, par une vue en coupe, une étape de dépôt d'une résine de protection 25 en face arrière de la structure illustrée en figure 5.

Lors de cette étape, on vient recouvrir intégralement (pleine plaque) la face supérieure de la structure illustrée en figure 5 par la résine 25, et en particulier combler les tranchées 23 et recouvrir la face arrière du substrat 11 (face supérieure du substrat 11 dans l'orientation de la figure 6). La résine 25 est par exemple, identique à la résine 21. A titre de variante, les résines 21 et 25 peuvent être différentes. La résine 25 est, par exemple, une résine époxy. La résine 25 permet d'isoler électriquement les bords et la face arrière (c'est-à-dire la face supérieure dans l'orientation de la vue A de la figure 1) de la puce finale et plus particulièrement le substrat semiconducteur 11.

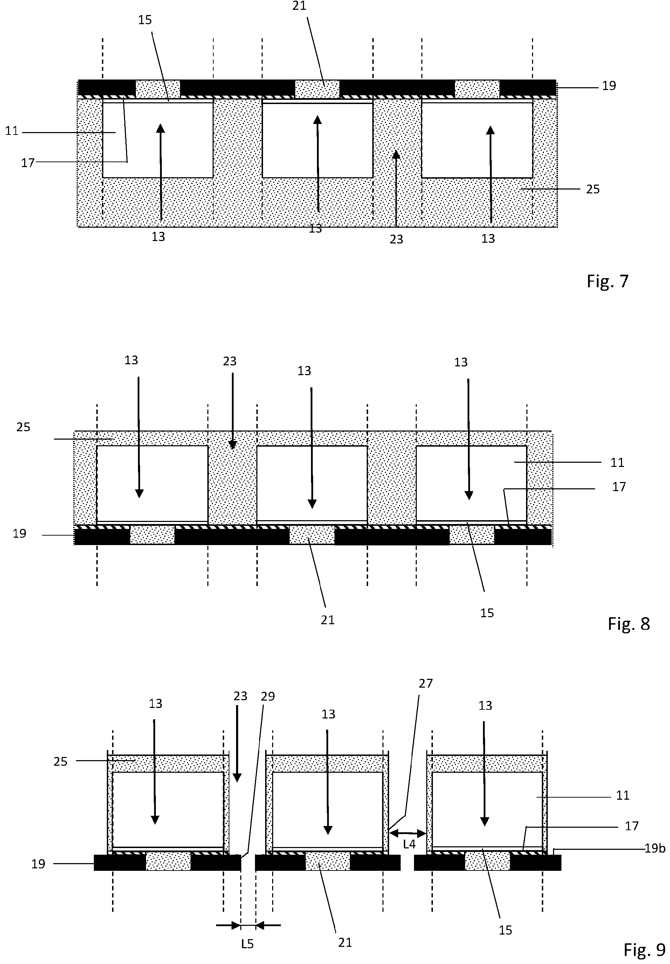

La figure 7 illustre, par une vue en coupe, une étape d'amincissement et de planarisation de la face avant de la structure illustrée en figure 6.

On notera que dans l'exemple de la figure 7, l'orientation de la structure est inversée par rapport aux vues en coupe des figures 5 et 6.

Lors de cette étape, on vient retirer une partie de l'épaisseur de la résine 21 (ou amincir), de façon à découvrir les contacts métalliques 19. La planarisation est, par exemple réalisée par polissage mécanique ou par polissage mécano-chimique (CMP, de l'anglais "Chemical Mechanical Polishing").

A l'issue de cette étape, les contacts métalliques 19 ne sont plus recouverts par la résine 21 et la résine 21 subsiste seulement entre les contacts métalliques 19. Ainsi, les contacts métalliques 19 affleurent au niveau de la face inférieure de la résine 21 dans l'orientation de la figure 7.

La figure 8 illustre, par une vue en coupe, une étape optionnelle d'amincissement, par la face arrière, de la structure illustrée en figure 7.

On notera que dans l'exemple de la figure 8, l'orientation de la structure est inversée par rapport à la vue en coupe de la figure 7.

Lors de cette étape, on vient retirer une partie de l'épaisseur de la résine 25. L'amincissement est par exemple réalisé par polissage mécanique ou par polissage mécano-chimique.

A l'issue de l'étape illustrée en figure 8, l'épaisseur de la structure est égale à l'épaisseur souhaitée des puces électroniques.

Dans l'exemple représenté, l'amincissement est interrompu avant d'atteindre la face arrière du substrat 11. Ainsi, une couche de résine de protection 25 subsiste en face arrière du substrat 11.

A titre de variante, si l'épaisseur du substrat 11 est trop importante par rapport à l'épaisseur de puce électronique finale souhaitée, l'amincissement peut être poursuivi jusqu'à retirer une partie de l'épaisseur du substrat 11 par sa face arrière (c'est-à-dire sa face supérieure dans l'orientation de la figure 8). L'amincissement peut alors être suivi par une étape de dépôt d'une troisième résine de protection sur la face supérieure de la structure afin de protéger la face arrière du substrat 11 aminci. La troisième résine est par exemple identique à la deuxième résine 25. A titre de variante, la troisième résine peut être différente de la deuxième résine. La troisième résine est, par exemple, en époxy. A titre de variante, la troisième résine peut être remplacée par un autre matériau de protection, par exemple un film solide ou tout autre matériau organique ou minéral, par exemple déposé par pulvérisation.

Dans une autre variante, l'étape d'amincissement du substrat 11 peut être réalisée avant la formation des tranchées 23, par exemple après le dépôt de la résine 21. A titre de variante, l'étape d'amincissement du substrat 11 peut être réalisée avant l'étape de dépôt de la première résine 21.

La figure 9 illustre, par une vue en coupe, une étape de formation de deuxièmes 27 et troisièmes 29 tranchées de découpe à partir de la face arrière de la structure illustrée en figure 8.

A l'issue de l'étape illustrée en figure 9, la structure correspond à des puces individuelles comprenant chacune un unique circuit intégré 13. Préalablement à cette étape, la structure est rapportée, par sa face avant (face inférieure dans l'orientation de la figure 9), sur un film support, non représenté en figure 9.

Lors de cette étape, les deuxièmes tranchées 27, sont d'abord formées dans la résine de protection 25 en vis-à-vis des premières tranchées 23. Des tranchées 27 sont réalisées en vis-à-vis de toutes les tranchées 23 et sur toute leur longueur. Les tranchées 27 s'étendent, dans la résine 25 jusqu'aux plots de reprise de contact 17 ou aux contacts métalliques 19. En d'autres termes, les deuxièmes tranchées s'étendent de la face supérieure de la structure illustrée en figure 9, sur toute l'épaisseur de la résine 25. Les tranchées 27 débouchent, par exemple, sur ou dans les plots 17. En variante, les tranchées 27 débouchent sur ou dans les contacts métalliques 19.

Les tranchées 27 ont une largeur L4. La largeur L4 est inférieure à la largeur L3 de sorte que le substrat 11 de chaque puce reste recouvert par la résine 25 sur ses quatre faces latérales. Les tranchées 27 peuvent, par exemple, être réalisées par sciage, en utilisant une lame de découpe de largeur inférieure à celle utilisée pour la réalisation des tranchées 23. Les tranchées 27 peuvent, en variante, être réalisées par ablation laser. Les tranchées 27 et les tranchées 23 sont par exemple alignées selon un même axe central.

Afin de découper la structure en puces individuelles comprenant chacune un unique circuit intégré 13, les troisièmes tranchées 29 sont réalisées en vis-à-vis des deuxièmes tranchées 27 dans les contacts métalliques 19. Plus particulièrement, on vient former en vis-à-vis de chaque deuxième tranchée 27, une tranchée 29 parallèle à ladite tranchée 27. Dans cet exemple, les tranchées 29 s'étendent sur toute la longueur des tranchées 27. Les tranchées 29 s'étendent, verticalement, de sorte que les contacts métalliques 19 et, le cas échéant, les plots 17 soient coupés en vis à vis des deuxièmes tranchées 27. Les tranchées 29 ont une largeur L5 inférieure à la largeur L4, de façon que, dans chaque puce, chaque contact métallique comprenne une patte 19b libre, en saillie du flanc de la couche de résine de protection latérale 25 du boîtier de la puce.

Les tranchées 29 peuvent, par exemple, être réalisées par sciage, en utilisant une lame de découpe de largeur inférieure à celle utilisée pour la réalisation des tranchées 27. Les tranchées 29 peuvent en variante être réalisées par ablation laser.

Dans cet exemple, la différence entre les largeurs L4 et L5 est choisie, d'une part, suffisamment grande pour permettre de dégager des pattes 19b des contacts métalliques 19. D'autre part, la largeur L5 doit être suffisamment faible pour qu'un maximum de puces puisse être réalisé à partir d'une même plaquette semiconductrice. La différence entre les largeurs L4 et L5 correspond à deux fois la longueur L1 des pattes 19b.

La largeur L5 est, par exemple, inférieure à 20 µm, de préférence de l'ordre de 10 µm, voire inférieure à 10 µm. La largeur L4 est alors de préférence comprise entre 30 µm et 310 µm de sorte que la différence entre les largeurs L4 et L5 soit comprise entre 20 µm et 300 µm, soit une longueur de pattes L1 comprise entre 10 µm et 150 µm.

A l'issue de cette étape, la structure obtenue correspond à une pluralité de puces électroniques, reliées uniquement par le film support (non représenté en figure 9). Les puces peuvent ensuite être prélevées sur ce film support, en vue de leur montage dans un dispositif extérieur.

Un avantage des modes de réalisation et des modes de mise en oeuvre décrits est qu'ils permettent de faciliter le montage des puces électroniques sur un circuit imprimé.

Un autre avantage des modes de réalisation et des modes de mise en oeuvre décrits est qu'ils permettent un contrôle visuel de la brasure lors du montage des puces sur un circuit imprimé, sans l'utilisation de techniques coûteuses, par exemple des techniques d'inspection par rayons X.

Un autre avantage des modes de réalisation et des modes de mise en oeuvre décrits est qu'ils permettent de diminuer l'épaisseur des puces électroniques à montage en surface et, par conséquent, l'épaisseur des circuits imprimés.

Un autre avantage des modes de réalisation et des modes de mise en oeuvre décrits est qu'ils permettent de réaliser des puces électroniques de petites dimensions présentant des pattes latérales de connexion électrique. Ceci permet notamment de réaliser des pattes latérales de connexion électriques en se passant d'un cadre métallique de support, relativement encombrant.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnés ci-dessus.

Les modes de réalisation décrits ne se limitent par ailleurs pas à l'agencement particulier des plots de reprise de contact 17 et des contacts métalliques 19 représentées sur les figures. A titre de variante, outre les contacts métalliques 19 situés en périphérie de la puce et présentant des pattes 19b s'étendant latéralement au-delà du boîtier de la puce, chaque puce peut comprendre, un ou plusieurs contacts métalliques situés dans une partie centrale de la face de connexion de la puce, ces contacts ne présentant alors pas de débordement latéral. La qualité de la connexion de ces contacts métalliques centraux au dispositif extérieur ne pourra alors pas être contrôlée directement par inspection visuelle. Toutefois, en pratique, l'inspection de la qualité des connexions des contacts périphériques pourra suffire à détecter d'éventuels défauts de montage. Si besoin, la qualité des connexions des contacts métalliques centraux peut éventuellement être contrôlée par des techniques d'inspection par rayons X.

Enfin, la mise en oeuvre pratique des modes de réalisation et variantes décrits est à la portée de la personne du métier à partir des indications fonctionnelles données ci-dessus.

## Revendications

1. Procédé de fabrication de puces électroniques (1) comprenant, dans l'ordre :
a. la formation de contacts métalliques (19) du côté d'une première face d'un substrat semiconducteur (11), dans et sur lequel ont été préalablement formés une pluralité de circuits intégrés (13), chaque contact métallique s'étendant à l'aplomb d'au moins deux circuits intégrés voisins ;
b. le dépôt d'une première résine de protection (21) sur les contacts métalliques (19) et la première face du substrat semiconducteur (11) ;
c. la formation de premières tranchées (23) d'une première largeur (L3), du côté d'une deuxième face du substrat semiconducteur (11) opposée à la première face, les premières tranchées (23) s'étendant entre les circuits intégrés (13) sur toute l'épaisseur du substrat semiconducteur (11) ;
d. le dépôt d'une deuxième résine de protection (25) dans les premières tranchées (23) et sur la deuxième face du substrat semiconducteur (11) ;
e. la formation de deuxièmes tranchées (27), d'une deuxième largeur (L4) inférieure à la première largeur (L3), dans la deuxième résine de protection (25), en vis-à-vis des premières tranchées (23), les deuxièmes tranchées s'étendant jusqu'aux contacts métalliques (19) ; et
f. la formation de troisièmes tranchées (29), d'une troisième largeur (L5) inférieure à la deuxième largeur (L4), en vis-à-vis des deuxièmes tranchées (27), les troisièmes tranchées traversant les contacts métalliques (19) de façon à individualiser les puces électroniques (1).

2. Procédé selon la revendication 1, comprenant, après l'étape b., une étape d'amincissement de la première résine de protection (21) de façon à découvrir les contacts métalliques (19).

3. Procédé selon la revendication 1 ou 2, comprenant, avant l'étape a., une étape de formation de plots de reprise de contact (17) du côté de la première face du substrat semiconducteur (11), les contacts métalliques (19) étant formés, lors de l'étape a., sur et en contact avec les plots de reprise de contact (17).

4. Procédé selon l'une quelconque des revendications 1 à 3, dans lequel les contacts métalliques (19) ont une hauteur comprise entre 20 µm et 150 µm.

5. Procédé selon l'une quelconque des revendications 1 à 4, dans lequel la troisième largeur (L5) est inférieure à 20 µm.

6. Procédé selon l'une quelconque des revendications 1 à 5, dans lequel la deuxième largeur (L4) est comprise entre 30 µm et 310 µm.

7. Procédé selon l'une quelconque des revendications 1 à 6, comprenant en outre, après l'étape a., une étape d'amincissement du substrat semiconducteur (11) par sa deuxième face.

8. Procédé selon la revendication 7, dans lequel ladite étape d'amincissement du substrat semiconducteur (11) est mise en oeuvre avant l'étape c..

9. Procédé selon la revendication 7, dans lequel ladite étape d'amincissement du substrat semiconducteur (11) est mise en oeuvre après l'étape d..

10. Puce électronique (1) comportant un circuit intégré (13) formé dans et sur un substrat semiconducteur (11), les flancs du substrat étant revêtus par une deuxième résine de protection (25), la puce comportant au moins un contact métallique (19) disposé sur une première face du substrat semiconducteur (11) et s'étendant latéralement au-delà des flancs de la deuxième résine de protection (25).

11. Puce (1) selon la revendication 10, dans lequel ledit au moins un contact métallique (19) présente une face de connexion plane s'étendant de façon continue en partie sous le substrat semiconducteur (11) et se prolongeant latéralement au-delà des flancs de la deuxième résine de protection (25).
